# FASCICULE DE BREVET EUROPEEN

(11) **EP 0 350 443 B1**
(45) Date de publication et mention de la délivrance du brevet: **26.05.1993**
(21) Numéro de dépôt: 89810467.4
(22) Date de dépôt: 16.06.1989
(51) Int. Cl.: H03H 9/19

(54) **Résonateur piézoélectrique**
Piezoelektrischer Resonator
Piezoelectric resonator

(30) Priorité: 07.07.1988 FR 8809221
(43) Date de publication de la demande: 10.01.1990
(73) Titulaire: CENTRE SUISSE D'ELECTRONIQUE ET DE MICROTECHNIQUE S.A., 2007 Neuchâtel (CH)
(72) Inventeur: Bourgeois, Claude, CH-2014 Bôle (CH); Hermann, Jean, CH-2000 Neuchâtel (CH)
(74) Mandataire: Brulliard, Joel

(56) Documents cités:
- EP-A- 0 086 739
- FR-A- 2 435 855
- US-A- 4 148 530

## Description

La présente invention concerne un résonateur piézoélectrique, vibrant selon un mode de contour, présentant une courbe caractéristique de variation de la fréquence en fonction de la température de type cubique et capable d'être réalisé par attaque chimique d'un substrat de quartz.

Un résonateur à mode de contour se présente sous la forme d'une plaque mince à mouvements dans le plan. L'épaisseur doit être suffisamment faible pour que les forces d'inertie provoquées par les mouvements hors du plan aient une influence négligeable sur l'énergie de déformation. La forme la plus couramment adoptée est le rectangle ce qui implique l'existence de quatre paramètres géométriques:
- deux angles de coupe pour définir la direction de la normale à la plaque;
- un angle de coupe pour définir l'orientation des côtés du rectangle dans le plan de la plaque, et
- un rapport dimensionnel entre les côtés du rectangle.

Pour qu'un résonateur présente un intérêt pratique, il faut que son coefficient thermique de premier ordre soit voisin de 0 à la température moyenne d'utilisation.

Il existe sur le marché des quartz de différentes coupes parmi lesquelles la coupe GT est celle qui présente les propriétés thermiques les plus favorables. Il s'agit d'une plaque rectangulaire dont le rapport dimensionnel est égal à 0,86, et qui est obtenue par une rotation autour de l'axe électrique X du cristal suivie d'une rotation ± 45° autour de la normale. Le résonateur de coupe GT oscille selon un mode de contour et plus particulièrement en mode d'allongement selon la petite dimension de la plaque. Les coefficients thermiques de premier et de deuxième ordre sont nuls, le coefficient de troisième ordre est très faible. L'inconvénient de cette coupe provient du fait que les propriétés thermiques du résonateur dépendent de façon critique du rapport dimensionnel de la plaque.

A titre d'exemple, pour un quartz de coupe GT, le coefficient thermique de premier ordre α est égal à ±0,1.10⁻⁶/°C, le coefficient de deuxième ordre β est égal à ±1.10⁻⁶/°C² et le coefficient de troisième ordre γ est inférieur à 30.10⁻¹²/°C³.

Cependant, il est à noter que pour une variation relative du rapport dimensionnel w/ℓ , égale à 1%, la variation du coefficient thermique de premier ordre est égale à 2,5.10⁻⁶/°C. Cela signifie que le coefficient thermique d'un quartz GT devra obligatoirement être ajusté après montage du résonateur.

Une autre coupe connue est la coupe DT qui consiste en une plaque généralement carrée, obtenue par une rotation autour de l'axe électrique X et vibrant selon un mode de cisaillement de surface. Les résonateurs de coupe DT ont l'avantage par rapport à ceux de coupe GT d'être peu sensibles aux variations du rapport dimensionnel. Cependant, leurs qualités thermiques sont moins bonnes. A titre d'exemple, le coefficient thermique de premier ordre α est nul, le coefficient thermique de deuxième ordre β est égal à -(15 à 20).10⁻⁹/°C² et le coefficient thermique de troisième ordre est approximativement égal à 45.10⁻¹²/°C³.

On connaît également des quartz de coupe AT qui se présentent sous la forme d'une plaque obtenue par une rotation autour de l'axe électrique X du cristal. Les données de ces quartz se retrouvent notamment dans la publication "Quartz vibrators and their applications" de Pierre Vigoureux, édité par His Majesty's Stationary Office, Londres, 1950. Deux types de quartz de coupe AT, oscillant à une fréquence de 4 MHz sont actuellement commercialisés. Il s'agit du quartz AT de la société Nihon Dempa dont les propriétés thermiques à 25°C sont les suivantes:
- Coefficient thermique de premier ordre : α = ±0,1.10⁻⁶/°C;
- Coefficient thermique de deuxième ordre : β = -4 ±1.10⁻⁹/°C²;
- Coefficient thermique de troisième ordre: γ = 95.10⁻¹²/°C³;

et du quartz AT de la Société Suisse pour l'industrie Horlogère (SSIH) dont les propriétés thermiques à 25°C sont les suivantes:
- Coefficient thermique de premier ordre : α = ±0,1.10⁻⁶/°C;
- Coefficient thermique de deuxième ordre : β = -11 ± 1.10⁻⁹/°C²;
- Coefficient thermique de troisième ordre: γ = 90.10⁻¹²/°C³.

Outre des propriétés thermiques inférieures à celles des quartz de coupe GT, les quartz de coupe AT ont une fréquence quatre fois plus élevée pour un encombrement comparable. D'autre part, le coefficient thermique de premier ordre est plus sensible aux différences de valeurs de l'angle de coupe. Par exemple, pour une variation Δφ de l'angle φ égale à 1°, la variation correspondante Δα du coefficient thermique du premier ordre est égale à 4,7.10⁻⁶/°C. En outre, le quartz AT de la société Nihon Dempa a une forme compliquée, présentant un biseautage à chaque extrémité du barreau et une inclinaison des faces latérales. Cela implique la nécessité d'une métallisation individuelle après usinage complet. Le quartz AT de la société SSIH a une longueur importante, soit d'environ 11mm.

Un autre résonateur également connu, présentant de bonnes propriétés thermiques et une quasi-indépendance du coefficient thermique de premier ordre au rapport dimensionnel w/ℓ est le résonateur à quartz de coupe ZT qui a été décrit dans le brevet français No 2 435 855. Un tel résonateur, dont la forme de base est un rectangle, peut également présenter une structure plus complexe par combinaison de plusieurs rectangles de base qui, du point de vue de la propagation des ondes élastiques, peuvent être considérés comme des rectangles pseudo-libres. Des exemples de telles combinaisons peuvent être trouvés dans le brevet précité de même que dans un autre brevet français portant le No 2 521 782 et décrivant des structures de résonateur encastrable de coupe ZT.

Les résonateurs de coupe ZT sont obtenus, à partir d'un substrat de coupe Z (c'est-à-dire une plaque ayant l'axe optique Z du cristal de quartz pour normale), par une première rotation autour de l'axe mécanique Y du cristal suivie d'une deuxième rotation autour de la normale au plan du résonateur. La nécessité d'avoir recours à deux rotations peut présenter certains inconvénients. En particulier, la deuxième rotation dans le plan du substrat implique une orientation oblique des résonateurs par rapport aux arêtes du substrat et, en conséquence, une utilisation non optimum de ce dernier. Par ailleurs, lorsque les résonateurs sont découpés par attaque chimique du substrat, les faces latérales perpendiculaires à la direction de l'onde de vibration sont obliques au lieu d'être perpendiculaires au plan du substrat. Cette obliquité des faces latérales peut engendrer des effets perturbateurs difficiles à compenser. Elle a, notamment, pour effet de favoriser le couplage entre le mode de contour désiré et des modes parasites de vibration hors du plan.

La présente invention se propose de remédier aux inconvénients susmentionnés des résonateurs connus et de réaliser un résonateur du type indiqué dans le préambule et ne nécessitant qu'une seule rotation autour de l'axe électrique X du cristal d'un substrat de coupe Z.

Un autre objet de l'invention est un résonateur dont les faces latérales perpendiculaires à la direction de l'onde de vibration sont perpendiculaires au plan du substrat lorsque le résonateur est réalisé à l'aide d'un procédé d'attaque chimique.

Encore un autre objet de l'invention est un résonateur comportant une pluralité de rectangles de base agencés de manière à permettre sa fixation à un boîtier par encastrement.

Selon une caractéristique de l'invention, le résonateur est réalisé dans une plaque de quartz mince et rectangulaire dont la largeur est dirigée selon l'axe électrique X du cristal, la longueur est dirigée selon un axe Y' et l'épaisseur est dirigée selon un axe Z'; les axes Y' et Z' formant avec, respectivement, les axes mécanique Y et optique Z du cristal un angle φ égal approximativement à 24°24' et dont le rapport w/ℓ de la largeur à la longueur est sensiblement égal à 0,64. Lorsqu'un tel résonateur est obtenu par attaque chimique d'une telle plaque, il est aisé de voir que les faces latérales parallèles à l'axe Y' sont dans le plan d'attaque privilégié (direction de l'axe Z) et seront, de ce fait, exactement perpendiculaires aux grandes surfaces du résonateur. Or comme cela a été mentionné précédemment, il est important que les formes réelles obtenues soient aussi proches que possible des formes idéales afin d'optimiser les performances du résonateur. Par ailleurs, la largeur du résonateur étant dirigée selon l'axe X, on comprend aisément que le découpage d'une série de résonateurs dans un substrat rectangulaire ayant pour arêtes les axes X et Y' correspond à une utilisation optimale de ce substrat. L'absence de rotation dans le plan du substrat entraîne un coût de fabrication des résonateurs de l'invention plus faible que celui des résonateurs de coupe ZT décrits dans les brevets précités.

D'autres objets, caractéristiques et avantages de la présente invention apparaîtront plus clairement à la lecture suivante d'exemples d'application particuliers, ladite description étant faite à titre d'exemple non limitatif et en relation avec les dessins joints dans lesquels:
- la figure 1 montre l'orientation de la structure de base d'un résonateur de l'invention par rapport aux axes cristallographiques X, Y, Z du quartz;
- la figure 2 est une vue en perspective du résonateur de la figure 1 montrant l'emplacement des électrodes;
- la figure 3 montre un résonateur obtenu par la combinaison de trois structures de base juxtaposées; et
- les figures 4 et 5 montrent des exemples de résonateurs de forme plus complexe et permettant leur fixation à un boîtier par encastrement.

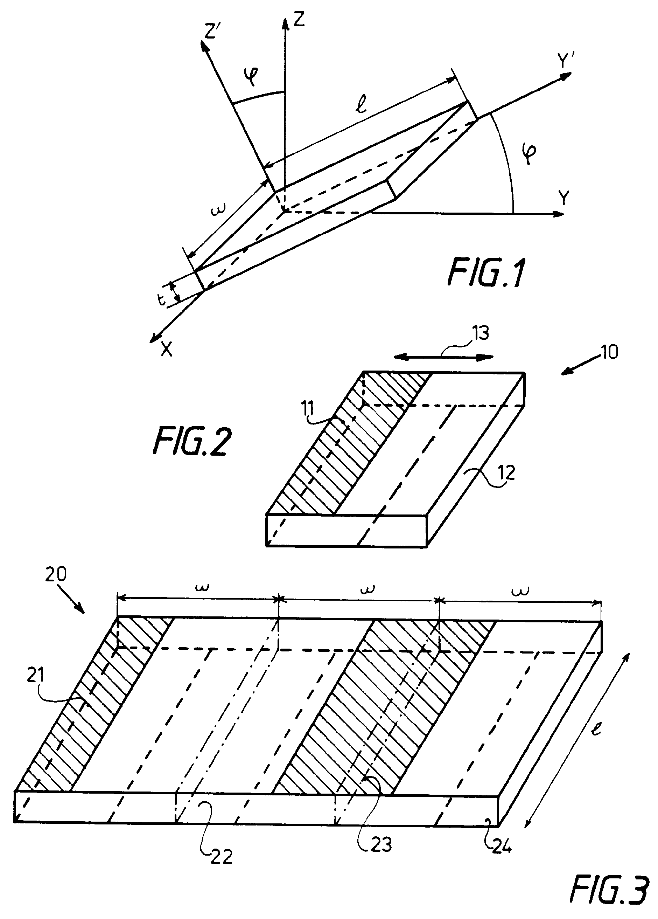

En référence à la figure 1, la plaque appelée par la suite plaque de coupe ZTX, s'obtient de préférence à partir d'un substrat de coupe ZY, c'est-à-dire une plaque dont la normale est constituée par l'axe optique Z du cristal de quartz, l'axe mécanique Y indiquant la direction de la longueur de la plaque. Une rotation d'angle φ autour de l'axe électrique X amène l'axe Y en Y' et l'axe Z en Z'. Les directions principales X, Y' et Z' correspondent respectivement à la largeur w, la longueur ℓ et l'épaisseur t de la plaque de coupe ZTX. Selon les normes IRE, "Standards on piezoelectric crystals, 1949" publiées dans Proceedings of the I.R.E., Vol. 37, No 12, Décembre 1949, une telle coupe est notée (Z Y W)φ. Le résonateur de l'invention est alors parfaitement défini lorsqu'est précisée la valeur de l'angle φ et du rapport dimensionnel de la largeur w à la longueur ℓ du résonateur. Les meilleurs résultats sont obtenus lorsque l'angle φ est approximativement égal à 24°24' et le rapport dimensionnel w/ℓ est approximativement égal à 0,64. On constate que la courbe caractéristique de variation de fréquence en fonction de la température est une courbe cubique dont le point d'inflexion (coefficient thermique de deuxième ordre) peut être adapté par un choix approprié du rapport dimensionnel. La valeur du coefficient thermique de premier ordre α, qui représente la pente de la courbe caractéristique au point d'inflexion, dépend de l'angle de coupe φ. Il peut être annulé ou ajusté à une valeur proche de zéro selon la grandeur de la plage de température dans laquelle le résonateur doit présenter de bonnes propriétés thermiques. Outre l'ajustement requis de l'angle de coupe φ et du rapport dimensionnel w/ℓ pour s'adapter aux conditions de fonctionnement choisies (température typique de fonctionnement et plage de température), il est également nécessaire de compenser certains effets perturbateurs qui ne peuvent être modélisés. Il y a lieu de tenir compte, en particulier, de l'effet de la métallisation (effet électrique, élastique et massique des électrodes), de la suspension du résonateur (soudure des fils de suspension ou bras de suspension et zones d'encastrement), de la valeur non nulle de l'épaisseur du résonateur, des tolérances de fabrication (obliquité de certaines faces due au procédé d'attaque chimique), etc. On comprend dès lors que les valeurs indiquées ci-dessus d'angle de coupe et de rapport dimensionnel sont des valeurs typiques dont on pourra s'écarter, 1 à 3° pour φ et 1 à 5% pour w/ℓ, pour optimiser le résonateur en fonction de l'application choisie. La largeur w et la longueur ℓ seront choisies en fonction de la fréquence de fonctionnement. La fréquence par unité de largeur est sensiblement égale à 2718 kHz.mm. L'épaisseur t est, comme dans tous les résonateurs à mode de contour, un paramètre relativement libre qui pourra être utilisé pour optimiser les performances du résonateur de l'invention.

La figure 2 montre un exemple de résonateur muni d'électrodes. Les électrodes 11 et 12 sont obtenues par métallisation partielle des grandes faces du résonateur 10 et sont symétriques l'une de l'autre par rapport au centre du résonateur. La largeur des métallisations est déterminée en fonction de la capacité dynamique voulue. La polarisation des électrodes engendre un champ électrique diagonal permettant d'exciter un mode d'allongement selon la direction indiquée par la flèche 13.

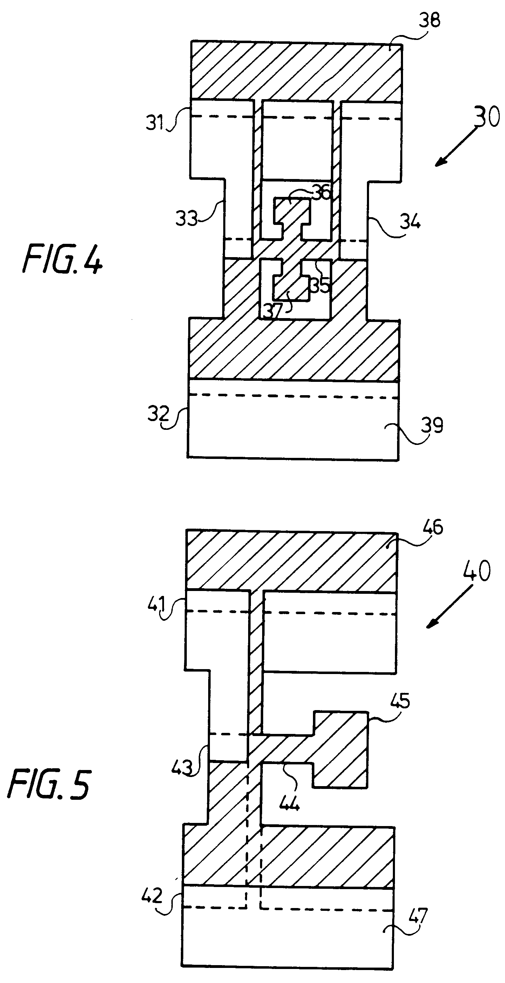

La figure 3 montre une première variante de l'invention qui consiste en une plaque 20 qui peut être considérée comme la combinaison de 3 résonateurs de base, dont la largeur w et la longueur ℓ sont telles que le rapport w/ℓ soit sensiblement égal à 0,64. La configuration des électrodes 21, 22, 23 et 24 est également illustrée sur la figure.

Il convient de noter que la variante de la figure 3 ne constitue qu'un exemple de configuration possible associant plusieurs structures de base et que, de manière générale, un nombre N de structures de base peuvent être combinées dans la mesure où la direction du mouvement de vibration est conservée.

Alors que les variantes représentées dans les figures 1 à 3 pouvaient être fixées à un boîtier par l'intermédiaire de fils de suspension fixés, par soudure, au centre des grandes faces des résonateurs, les variantes des figures 4 et 5 peuvent être fixées à un boîtier par l'intermédiaire d'un bras de suspension, solidaire du résonateur et comportant une zone d'encastrement.

La figure 4 montre un résonateur 30 qui comporte deux plaques rectangulaires 31 et 32 reliées par deux bras résonnants 33 et 34. Les bras résonnants sont reliés par un bras de suspension 35 à deux zones d'encastrement 36 et 37. Les métallisations des électrodes 38 et 39 sont représentées par une zone hachurée pour une des faces et par un contour en pointillé pour l'autre face. La forme de la figure 4 a déjà été décrite dans le brevet français 2 521 782 précité, mais elle reste applicable à un résonateur selon la présente invention. Les plaques 31 et 32 ainsi que les bras résonnants 33 et 34 constituent autant de résonateurs de base tels que celui décrit en relation avec la figure 1. Il est bien évident que, comme dans le cas du brevet cité précédemment, les zones d'encastrement peuvent n'être reliées qu'à un seul des bras résonnants.

La figure 5 illustre une autre forme de résonateur encastrable 40 ne comportant plus qu'un seul bras résonnant 43, reliant deux plaques 41 et 42 et connecté à une zone d'encastrement 45 par un bras de suspension 44. Comme dans le cas de la figure 4, les plaques 41 et 42 et le bras résonnant 43 constituent autant de résonateurs de base. La configuration des électrodes 46 et 47 est également représentée de manière analogue à celle de la figure 4.

Bien que la présente invention ait été décrite dans le cadre d'exemples particuliers, il est clair cependant qu'elle n'est pas limitée à ces exemples et qu'elle est susceptible de modifications et de variantes sans sortir de son domaine. La possibilité, en particulier, de combiner plusieurs structures de base, par exemple, pour travailler à des fréquences de vibration élevées ou pour réaliser une structure présentant au moins une zone d'évanescence qui permette l'encastrement du résonateur, laisse envisager une pluralité de variantes autres que celles décrites dans la description.

## Revendications

1. Résonateur piézoélectrique vibrant selon un mode de contour, réalisé dans une plaque mince de quartz, ayant la forme d'un parallélépipède rectangle dont la largeur w est dirigée selon l'axe électrique X du cristal, la longueur ℓ est dirigée selon un axe Y' et l'épaisseur t est dirigée selon un axe Z', caractérisé en ce que lesdits axes Y' et Z' forment avec, respectivement, les axes mécanique Y et optique Z du cristal un angle φ égal à 24° 24'± 3° et en ce que le rapport w/ℓ de la largeur à la longueur est égal à N.(0,64 ± 0,03), où N est un entier.

2. Résonateur selon la revendication 1, caractérisé en ce que N est égal à 1.

3. Résonateur selon la revendication 1, caractérisé en ce que N est égal à 3.

4. Résonateur selon l'une des revendications 1 à 3, caractérisé en ce qu'il comporte des électrodes (11, 12; 21, 22, 23, 24; 38, 39 et 46, 47) disposées et polarisées de manière à exciter un mode de vibration de contour.

5. Résonateur selon la revendications 4, caractérisé en ce que ledit mode de contour est un mode d'allongement dans le sens de la largeur w.

6. Résonateur selon la revendication 1, caractérisé en ce qu'il comporte deux plaques parallélépipédiques rectangulaires (31, 32 et 46, 47) reliées entre elles par au moins un bras résonnant (33, 34 et 43) et en ce que ledit bras résonnant est relié à au moins une zone d'encastrement (36, 37 et 45).

7. Résonateur selon la revendication 6, caractérisé en ce que lesdites plaques parallélépipédiques rectangulaires sont reliées entre elles par deux bras résonnants (33, 34) et en ce que lesdits bras sont reliés à au moins une zone d'encastrement (36, 37) par un bras de suspension (35).

## Patentansprüche

1. Gemäß einem Konturmodus vibrierender piezoelektrischer Resonator, hergestellt in einer dünnen Quarz Platte, mit der Form eines rechtwinkligen Parallelepipeds, dessen Breite w in Richtung der elektrischen Achse X des Kristalls gerichtet ist, dessen Länge ℓ in Richtung einer Achse Y' grichtet ist, und dessen Dicke t in Richtung einer Achse Z' gerichtet ist, dadurch gekennzeichnet, daß die genannten Achsen Y' bzw. Z' mit der mechanischen Achse Y bzw. der optischen Achse Z des Kristalls einen Winkel φ gleich 24° 24 Minuten ± 3° bilden und daß das Verhältnis w/ℓ der Breite zur Länge gleich N.(0,64 ± 0,03) ist, wobei N eine ganze Zahl ist.

2. Resonator nach Anspruch 1, dadurch gekennzeichnet, daß N gleich 1 ist.

3. Resonator nach Anspruch 1, dadurch gekennzeichnet, daß N gleich 3 ist.

4. Resonator nach einem der Ansprüche 1 bis 3, dadurch gekennzeichnet, daß er Elektroden (11, 12; 21, 22, 23, 24, 38, 39 und 46, 47) umfaßt, die derart angeordnet und polarisiert sind, daß ein Konturvibrationsmodus erregt wird.

5. Resonator nach Anspruch 4, dadurch gekennzeichnet, daß der Konturmodus ein Verlängerungsmodus in Richtung der Breite w ist.

6. Resonator nach Anspruch 1, dadurch gekennzeichnet, daß er zwei rechtwinklige parallelepipedische Platten (31, 32 und 46, 47) umfaßt, die miteinander durch mindestens einen schwingenden Arm (33, 34 und 43) verbunden sind und daß der schwingende Arm mit mindestens einer Einspannzone (36, 37 und 45) verbunden ist.

7. Resonator nach Anspruch 6, dadurch gekennzeichnet, daß die rechtwinkligen parallelepipedischen Platten miteinander über zwei schwingende Arme (33, 34) verbunden sind und daß die Arme mit mindestens einer Einspannzone (36, 37) über einen Aufhängearm (35) verbunden ist.

## Claims

1. Piezoelectric resonator vibrating in a contour mode, produced from a thin quartz plate, having the form of a rectangular parallelepiped, where the width w lies along the electrical axis X of the crystal, the length l lies along an axis Y' and the thickness t lies along an axis Z',
characterised in that the said axes Y' and Z' form with respectively the mechanical axis Y and optical axis Z of the crystal an angle φ of 24° 24' ± 3° and in that the ratio w/l of the width to the length is equal to n.(0.64 ± 0.03), where n is an integer.

2. Resonator according to Claim 1, characterised in that n is equal to 1.

3. Resonator according to Claim 1, characterised in that n is equal to 3.

4. Resonator according to one of Claims 1 to 3, characterised in that it includes electrodes (11, 12; 21, 22, 23, 24; 38, 39 and 46, 47) disposed and biased so as to excite a contour vibration mode.

5. Resonator according to Claim 4, characterised in that the said contour mode is an extension mode in the direction of the width w.

6. Resonator according to Claim 1, characterised in that it includes two rectangular parallelepipedal plates (31, 32 and 46, 47) connected to each other by at least one resonating arm (33, 34 and 43) and in that the said resonating arm is connected to at least one rigid fixing zone (36, 37 and 45).

7. Resonator according to Claim 6, characterised in that the said rectangular parallelepipedal plates are connected to each other by two resonating arms (33, 34) and in that the said arms are connected to at least one rigid fixing zone (36, 37) by a suspension arm (35).
